# EUROPEAN PATENT APPLICATION

(11) **EP 4 761 035 A1**
(43) Date of publication of application: **17.06.2026**
(21) Application number: 25172592.5
(22) Date of filing: 25.04.2025
(51) Int. Cl.: H02J 4/00, H02J 9/06

(54) **BYPASS MODULE**

(30) Priority: 16.12.2024 CN 202423104569 U
(71) Applicant: Vertiv Corporation, Westerville, OH 43082 (US)
(72) Inventor: WANG, Jianwei, Shenzhen, 518055 (CN)
(74) Representative: Harden, Henry Simon

(57) **Abstract**

Provided in the present disclosure is a bypass module, including a chassis, thyristor components and a busbar component. Thyristor components include an insulating plate fixed within the chassis, heat sinks and thyristors. The busbar component includes bridging busbars electrically connected to the heat sinks and vertical busbars for electrically connecting the bridging busbars to a counter plug terminal, the counter plug terminal includes an input terminal and an output terminal, and the input terminal and the output terminal are electrically connected to the vertical busbars respectively. In the bypass module provided by the present disclosure, the heat sinks are electrically connected to the input terminal and the output terminal of the counter plug terminal of the cabinet through the bridging busbars and the vertical busbars. In this way, a utilization of the internal space of the chassis can be effectively improved, so that the bypass module is more reasonable and a size of the bypass module is reduced, so that ease of maintenance of the bypass module by an operator is effectively improved.

## Description

The present application claims priority to Chinese Patent Application No. 202423104569.0, titled "BYPASS MODULE", filed on December 16, 2024 with the China National Intellectual Property Administration, which is incorporated herein by reference in its entirety.

### FIELD

The present disclosure relates to the technical field of power supply modules, in particular to a bypass module.

### BACKGROUND

Bypass modules on the market have unreasonable internal structure layouts, resulting in low utilization of the internal space. Therefore, the bypass module has a large size and the installation of it to a cabinet is complicated, which may affect ease of maintenance of the bypass module by an operator.

### SUMMARY

An objective of the present disclosure is to provide a bypass module, with which the following shortcomings of the conventional bypass module are solved. Conventionally, a bypass module has an unreasonable internal structure layout, resulting in low utilization of the internal space. Therefore, the bypass module has a large size and the installation of it to a cabinet is complicated, which may affect ease of maintenance of the bypass module by an operator.

Technical solutions provided in the present disclosure for solving the above technical problems are described below. A bypass module is provided, including a chassis, multiple thyristor components arranged in the chassis, and a busbar component configured to electrically connect the thyristor components to a counter plug terminal of a cabinet.

The thyristor components include an insulating plate fixed within the chassis, multiple heat sinks arranged on the insulating plate, and thyristors arranged between the heat sinks; the busbar component includes multiple bridging busbars electrically connected to the heat sinks and multiple vertical busbars for electrically connecting the bridging busbars to the counter plug terminal; the counter plug terminal includes an input terminal and an output terminal; the input terminal and the output terminal are electrically connected to the vertical busbars.

Further, two thyristor components are arranged in the chassis, two heat sinks are arranged on the insulating plate of each of the two thyristor components, and a first heat sink, a second heat sink, a third heat sink and a fourth heat sink are formed within the chassis.

Further, the vertical busbars include an input vertical busbar which is electrically connected to the input terminal, the bridging busbars include an input bridging busbar electrically connected to the second heat sink and the fourth heat sink, and a fuse is provided between the input bridging busbar and the input vertical busbar.

Further, the fuse is electrically connected to the input bridging busbar via a first transfer busbar.

Further, the vertical busbars further include an output vertical busbar electrically connected to the output terminal, the bridging busbars further include an output bridging busbar electrically connected to the first heat sink and the third heat sink, and the output bridging busbar is electrically connected to the output vertical busbar via a second transfer busbar.

Further, a locating structure is provided between the two heat sinks of the insulating plate, and the locating structure includes a connecting column provided on one of the heat sinks and a fixing column provided on the other one of the heat sinks.

Further, the connecting column is inserted into the fixing column and is locked and fixed by means of a locking piece, so that the two heat sinks on the insulating plate are fixedly connected to each other.

Further, an elastic sheet is provided on each of the input terminal and the output terminal, for clamping and fixing the vertical busbars.

Further, the chassis is further provided with multiple ventilation holes for communication between the thyristor components and an external environment, and handles provided on both sides of the ventilation holes.

Advantageous effects of the bypass module provided by the present disclosure are described below. The multiple heat sinks are fixed within the chassis via the insulating plate, and the heat sinks are electrically connected to the input terminal and the output terminal of the counter plug terminal of the cabinet through the bridging busbars and the vertical busbars. In this way, a utilization of the internal space of the chassis can be effectively improved, so that the bypass module is more reasonable and a size of the bypass module is reduced. Additionally, the heat sinks in the thyristor components are electrically connected to the bridging busbars, and the bridging busbars are electrically connected to the counter plug terminal through the vertical busbars, so that the bypass module can be installed in or removed from the cabinet by simply inserting or pulling out the vertical busbars into/from the counter plug terminal of the cabinet. In this way, ease of maintenance of the bypass module by an operator installing the bypass module in the cabinet or removing the bypass module from the cabinet is effectively improved.

### BRIEF DESCRIPTION OF THE DRAWINGS

Figure 1 is a first schematic structural diagram of a bypass module according to the present disclosure;
Figure 2 is a second schematic structural diagram of a bypass module according to the present disclosure;
Figure 3 is a schematic structural diagram of a thyristor component in a bypass module according to the present disclosure; and
Figure 4 is an exploded schematic diagram of a thyristor component in a bypass module according to the present disclosure.

Reference numerals in the drawings are listed below:
100-Bypass module;
10-Chassis, 11-Ventilation hole, 12-Handle, 20-Thyristor component, 21-Heat sink;
211-First heat sink, 212-Second heat sink, 213-Third heat sink, 214-Fourth heat sink;
22-Insulating plate, 23-Thyristor, 24-Locating structure, 241-Connecting column, 242-Fixing column;
30-Busbar component, 31-Input vertical busbar, 32-Input bridging busbar;
33-Output vertical busbar, 34-Output bridging busbar, 40-Counter plug terminal, 41-Input terminal;
42-Output terminal, 50-Fuse, 60-First transfer busbar, 61-Second transfer busbar.

### DETAILED DESCRIPTION

To make the objectives, technical solutions, and advantages of the present disclosure clearer, the present disclosure is described in further detail below in conjunction with the drawings and the embodiments. It should be understood that the embodiments described herein are only for explaining the present disclosure, and are not intended to limit the present disclosure.

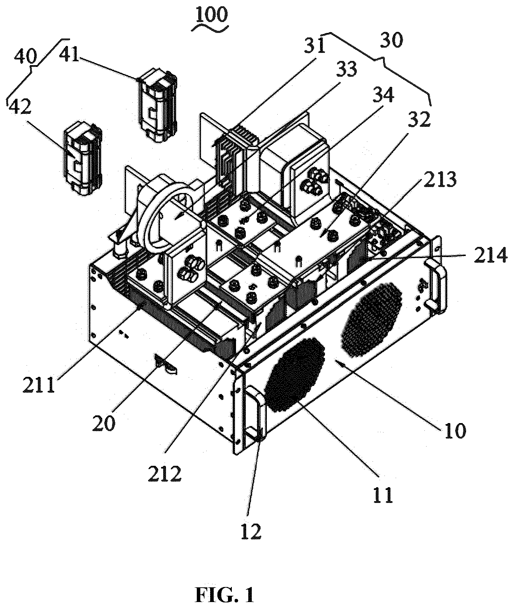

Reference is made to Figure 1 to Figure 4, which show a bypass module 100 provided in the present disclosure. The bypass module 100 includes a chassis 10, multiple thyristor components 20 arranged in the chassis 10, and a busbar component 30 configured to electrically connect the thyristor components 20 to a counter plug terminal 40 of a cabinet. The thyristor components 20 include an insulating plate 22 fixed within the chassis 10, multiple heat sinks 21 arranged on the insulating plate 22, and thyristors 23 arranged between the heat sinks 21. The busbar component 30 includes multiple bridging busbars electrically connected to the heat sinks 21 and multiple vertical busbars for electrically connecting the bridging busbars to the counter plug terminal 40. The counter plug terminal 40 includes an input terminal 41 and an output terminal 42. The input terminal 41 and the output terminal 42 are electrically connected to the vertical busbars. In the bypass module 100 provided by the present disclosure, the multiple heat sinks 21 are fixed within the chassis 10 via the insulating plate 22, and the heat sinks 21 are electrically connected to the input terminal 41 and the output terminal 42 of the counter plug terminal 40 of the cabinet through the bridging busbars and the vertical busbars. In this way, a utilization of the internal space of the chassis 10 can be effectively improved, so that the bypass module 100 is more reasonable and a size of the bypass module 100 is reduced. Additionally, the heat sinks 21 in the thyristor components 20 are electrically connected to the bridging busbars, and the bridging busbars are electrically connected to the counter plug terminal 40 through the vertical busbars, so that the bypass module 100 can be installed in or removed from the cabinet by simply inserting or pulling out the vertical busbars into/from the counter plug terminal 40 of the cabinet. In this way, ease of maintenance of the bypass module 100 by an operator installing the bypass module 100 in the cabinet or removing the bypass module 100 from the cabinet is effectively improved.

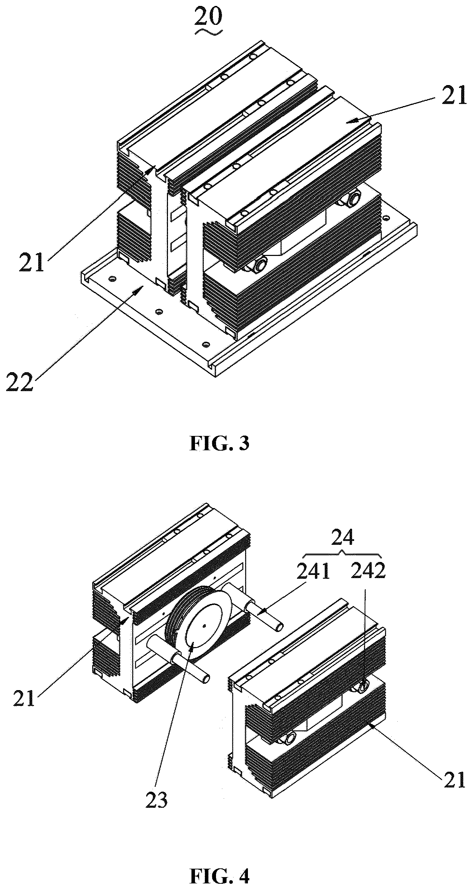

As shown in Figure 3 and Figure 4, in an embodiment of the present disclosure, two thyristor components 20 are arranged in the chassis 10, two heat sinks 21 are arranged on the insulating plate 22 of each of the thyristor components 20, and a first heat sink 211, a second heat sink 212, a third heat sink 213 and a fourth heat sink 214 are formed within the chassis 10. The two heat sinks 21 on the insulating plate 22 are electrically connected to each other through the thyristor 23, that is, the first heat sink 211 and the second heat sink 212 are electrically connected to each other through a thyristor 23 therebetween, and the third heat sink 213 and the fourth heat sink 214 are electrically connected to each other through a thyristor 23 therebetween. In addition, a fixing hole is provided on the thyristor 23. A locking piece, such as a bolt, a stud or a pin, is passed through the fixing hole on the thyristor 23 and locked at the heat sink 21. In this way, a stability of the fixed connection between the thyristor 23 and the heat sink 21 can be effectively improved, so that a stability of the electrical connection between the first heat sink 211 and the second heat sink 212 through the thyristor 23 and a stability of the electrical connection between the third heat sink 213 and the fourth heat sink 214 through the thyristor 23 are improved.

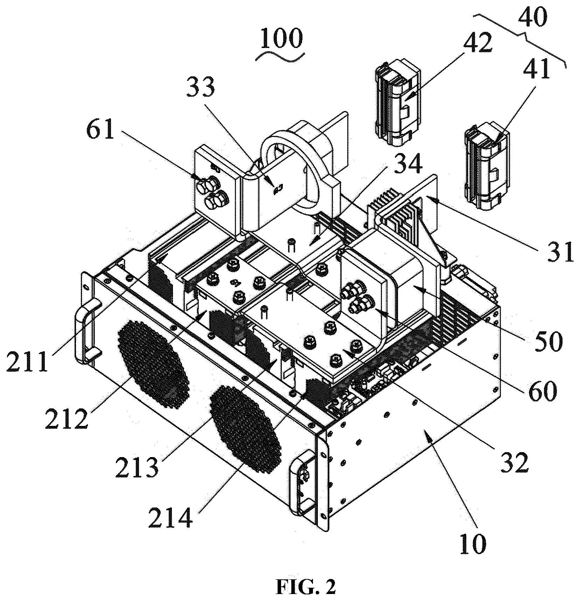

As shown in Figure 1 and Figure 2, the vertical busbars include an input vertical busbar 31 electrically connected to the input terminal 41, the bridging busbars include an input bridging busbar 32 electrically connected to the second heat sink 212 and the fourth heat sink 214, and a fuse 50 is provided between the input bridging busbar 32 and the input vertical busbar 31. The input bridging busbar 32 is fixed to the second heat sink 212 and the fourth heat sink 214 by a locking piece such as a bolt, a stud, or a pin. In this way, the stability of the electrical connection between the input bridging busbar 32 and the second heat sink 212 and the fourth heat sink 214 can be effectively guaranteed. In addition, the input busbar is fixed to the fuse 50 and the fuse 50 is fixed to the first transfer busbar 60 by a locking piece such as a bolt, a stud, or a pin. In this way, the stability of the electrical connection between the input busbar and the fuse 50 and the stability of the electrical connection between the fuse 50 and the first transfer busbar 60 can be effectively guaranteed.

As shown in Figure 1 and Figure 2, the fuse 50 is electrically connected to the input bridging busbar 32 through the first transfer busbar 60. The fuse 50 is fixed to the first transfer busbar 60 and the first transfer busbar 60 is fixed to the input bridging busbar 32 by a locking piece such as a bolt, a stud or a pin, so that the stability of the electrical connection between the fuse 50 and the first transfer busbar 60 and the stability of the electrical connection between the first transfer busbar 60 and the input bridging busbar 32 can be effectively guaranteed. In addition, in an embodiment of the present disclosure, the input terminal 41 inputs a current to the input vertical busbar 31, and the current flows through the fuse 50, then flows through the first transfer busbar 60 to the input bridging busbar 32, and thereby flows through the input bridging busbar 32 and through the fourth heat sink 214 to the second heat sink 212, and flows to the third heat sink 213 through the thyristor 23 between the fourth heat sink 214 and the third heat sink 213.

As shown in Figure 1 and Figure 2, the vertical busbars further include an output vertical busbar 33 electrically connected to the output terminal 42, the bridging busbars further include an output bridging busbar 34 electrically connected to the first heat sink 211 and the third heat sink 213, and the output bridging busbar 34 is electrically connected to the output vertical busbar 33 via a second transfer busbar 61. The output bridging busbar 34 is fixed to the first heat sink 211 and the third heat sink 213 by a locking piece such as a bolt, a stud, or a pin. In this way, the stability of the electrical connection between the output bridging busbar 34 and the first heat sink 211 and the third heat sink 213 can be effectively guaranteed. In addition, the output busbar is fixed to the fuse 50 and the fuse 50 is fixed to the second transfer busbar 61 by a locking piece such as a bolt, a stud, or a pin. In this way, the stability of the electrical connection between the output busbar and the fuse 50 and the stability of the electrical connection between the fuse 50 and the second transfer busbar 61 can be effectively guaranteed. The fuse 50 is electrically connected to the output bridging busbar 34 through the second transfer busbar 61. The fuse 50 is fixed to the second transfer busbar 61 and the second transfer busbar 61 is fixed to the output bridging busbar 34 by a locking piece such as a bolt, a stud or a pin, so that the stability of the electrical connection between the fuse 50 and the second transfer busbar 61 and the stability of the electrical connection between the second transfer busbar 61 and the output bridging busbar 34 can be effectively guaranteed.

As shown in Figure 2, in an embodiment of the present disclosure, the input terminal 41 inputs a current to the input vertical busbar 31, and the current flows through the fuse 50, then flows through the first transfer busbar 60 to the input bridging busbar 32, and thereby flows through the input bridging busbar 32 and through the fourth heat sink 214 to the second heat sink 212, and flows to the third heat sink 213 through the thyristor 23 between the fourth heat sink 214 and the third heat sink 213. The current on the third heat sink 213 flows through the output bridging busbar 34 to the first heat sink 211 and the output vertical busbar 33, and flows to the output terminal 42. The current flowing to the second heat sink 212 flows to the first heat sink 211 through the thyristor 23 between the second heat sink 212 and the first heat sink 211, and flows through the second transfer busbar 61 to the output vertical busbar 33 and then flows to the output terminal 42.

As shown in Figure 4, a locating structure 24 is provided between the two heat sinks 21 of the insulating plate 22, and the locating structure 24 includes a connecting column 241 provided on one of the heat sinks 21 and a fixing column 242 provided on the other one of the heat sinks 21. In the embodiment, the connecting column 241 is inserted into the fixing column 242 and is locked and fixed by means of a locking piece, so that the two heat sinks 21 on the insulating plate 22 are fixedly connected to each other.

In an embodiment of the present disclosure, a stud is provided on the connecting column 241, and a nut is provided on the fixing column 242. The stud on the connecting column 241 is inserted into the fixing column 242 and locked with the nut on the fixing column 242, so that a positioning accuracy between the two heat sinks 21 on the insulating plate 22 can be effectively improved, and the stability of the fixed connection between the two heat sinks 21 on the insulating plate 22 is ensured.

As shown in Figure 1 and Figure 2, in an embodiment of the present disclosure, an elastic sheet is provided on each of the input terminal 41 and the output terminal 42, for clamping and fixing the vertical busbars. The input vertical busbar 31 and the output vertical busbar 33 are embedded into the elastic sheets of the input terminal 41 and the output terminal 42, so that the stability of the electrical connection of the input vertical busbar 31 and the output vertical busbar to the input terminal 41 and the output terminal 42 can be effectively guaranteed, and the ease of installation and separation between the bypass module 100 and the counter plug terminal 40 of the cabinet can be improved. Further, the chassis 10 is further provided with multiple ventilation holes 11 for communication between the thyristor components 20 and an external environment, and handles 12 provided on both sides of the ventilation holes 11. In an embodiment of the present disclosure, heat loss of the thyristor 23 between the two heat sinks 21 is delivered through the heat sinks 21, and subjects to forced heat dissipation through a module fan on the chassis 10. The heat dissipation effect of the heat sinks 21 can be further improved through the ventilation holes 11 on the chassis 10, and thereby secure use of the bypass module 100 is ensured. In addition, with the handles 12 provided on both sides of the ventilation holes 11, ease of maintenance of the bypass module 100 by an operator inserting or pulling out the chassis 10 into/from a system cabinet along a guide rail is further improved.

The above are only preferred embodiments of the present disclosure and are not intended to limit the present disclosure. Any modifications, equivalent substitutions and improvements made within the spirit and principles of the present disclosure should be included in the protection scope of the present disclosure.

## Claims

1. A bypass module, comprising a chassis (10), a plurality of thyristor components (20) arranged in the chassis (10), and a busbar component (30) configured to electrically connect the thyristor components (20) to a counter plug terminal (40) of a cabinet;
the thyristor components (20) comprise an insulating plate (22) fixed within the chassis (10), a plurality of heat sinks (21) arranged on the insulating plate (22), and thyristors (23) arranged between heat sinks (21);
the busbar component (30) comprises a plurality of bridging busbars electrically connected to the heat sinks (21) and a plurality of vertical busbars for electrically connecting the bridging busbars to the counter plug terminal (40); and
the counter plug terminal (40) comprises an input terminal (41) and an output terminal (42), and the input terminal (41) and the output terminal (42) are electrically connected to vertical busbars, respectively.

2. The bypass module according to claim 1, wherein two thyristor components (20) are arranged in the chassis (10), two heat sinks (21) are arranged on the insulating plate (22) of each of the two thyristor components (20), and a first heat sink (211), a second heat sink (212), a third heat sink (213) and a fourth heat sink (214) are formed within the chassis (10).

3. The bypass module according to claim 2, wherein the vertical busbars comprise an input vertical busbar (31) electrically connected to the input terminal (41), the bridging busbars comprise an input bridging busbar (32) electrically connected to the second heat sink (212) and the fourth heat sink (214), and a fuse (50) is provided between the input bridging busbar (32) and the input vertical busbar (31).

4. The bypass module according to claim 3, wherein the fuse (50) is electrically connected to the input bridging busbar (32) via a first transfer busbar (60).

5. The bypass module according to claim 4, wherein the vertical busbars further comprise an output vertical busbar (33) electrically connected to the output terminal (42), the bridging busbars further comprise an output bridging busbar (34) electrically connected to the first heat sink (211) and the third heat sink (213), and the output bridging busbar (34) is electrically connected to the output vertical busbar (33) via a second transfer busbar (61).

6. The bypass module according to claim 1, wherein a locating structure (24) is provided between the two heat sinks (21) of the insulating plate (22), and the locating structure (24) comprises a connecting column (241) provided on one of the heat sinks (21) and a fixing column (242) provided on the other one of the heat sinks (21).

7. The bypass module according to claim 6, wherein the connecting column (241) is inserted into the fixing column (242) and is locked and fixed by means of a locking piece.

8. The bypass module according to claim 1, wherein an elastic sheet is provided on each of the input terminal (41) and the output terminal (42), for clamping and fixing the vertical busbars.

9. The bypass module according to claim 1, wherein the chassis (10) is further provided with a plurality of ventilation holes (11) for communication between the thyristor components (20) and an external environment, and handles (12) provided on both sides of the ventilation holes (11).
